# EUROPEAN PATENT APPLICATION

(11) **EP 4 753 391 A2**
(43) Date of publication of application: **03.06.2026**
(21) Application number: 26173167.3
(22) Date of filing: 15.11.2023
(51) Int. Cl.: H05K 7/20

(54) **A DATA PROCESSING APPARATUS AND METHOD OF PROVIDING ENERGY TO AN ENERGY CONSUMING SYSTEM**

(30) Priority: 18.11.2022 GB 202217333
(62) Divisional of application: 23818311.5
(71) Applicant: BBG Holdings GmbH, 1100 Wien (AT)
(72) Inventor: DIETRICH, Alexander, 1100 Vienna (AT)
(74) Representative: Keltie LLP

(57) **Abstract**

There is provided an energy regulator for providing electrical energy to or consuming electrical energy from an electrical energy generating system and providing heat energy to a heat consuming system coupled to the energy regulator in use. The energy regulator comprises at least one electronic data processing device configured, in use, to process data, a cool matter stream configured to thermally couple to the at least one electronic data processing device and capture heat energy produced by the at least one electronic data processing device in use, an energy store configured to store energy, and a load controller for controlling the at least one electronic data processing device, the energy store or the cool matter stream. The load controller is configured to receive an electrical energy regulation parameter enabling a required electrical energy level of the electrical energy generating system to be determined, receive a heat energy demand parameter enabling a required heat energy demand of the heat energy consuming system to be determined, generate and send instructions that cause a change in the operation of the at least one data processing device, the energy store or the cool matter stream, wherein the instructions are determined to cause a change in the temperature of the cool matter stream to meet the required heat energy demand and/or to cause a change in the electrical energy consumed by or provided to the electrical energy generating system to regulate the electrical energy generating system to meet the required electrical energy level, and enable output of the cool matter stream to the heat energy consuming system to meet at least part of the required heat energy demand and/or electrical energy input from or output to the electrical energy generating system to meet the required electrical energy level.

## Description

### TECHNICAL FIELD

The present invention relates to a system for meeting energy demands of an energy consuming system, and to a data processing apparatus and method of providing energy to an energy consuming system. More particularly, though not exclusively, the present invention relates to using data centres that use the heat produced by data processing devices to meet the energy demands of an energy consuming system and that can also help to regular electrical power supply generators.

### BACKGROUND

Sustainability is becoming an essential consideration for every industry, with businesses looking for ways to make their operations more energy efficient. Sustainability of businesses can be improved by using more energy efficient methods for heating buildings, using more sustainable forms of electricity, and reducing waste where possible.

Datacentres are often used by organisations for processing large amounts of data, and in recent years new technologies in industries such as finance, scientific research, and artificial intelligence, require the use of increasingly complex computers, such as crypto-mining servers and High-Performance Computing computers (HPCs).

However, highly complex computing systems such as those described above, use a huge amount of energy and also generate a significant amount of heat while operating, which is normally wasted. A system that can capture the waste heat, and use that heat for some application, is highly desirable as such as system reduces the waste heat from, and therefore improves the sustainability of, complex computing systems and datacentres. An application for the waste heat is to provide heating and hot water to buildings. Buildings, including offices, factories, and even homes, consume a huge amount of energy, with a large portion of the energy used for heating. A system that uses the waste heat produced by computers (generated by the computers carrying out required processing tasks for organisations) for heating buildings offers an extremely energy efficient heating system.

A heating system that uses this principle, where heat produced by computers is used to provide heat/hot water to buildings, is described in US9958882. This system uses cloud computing, where computing tasks are distributed across multiple computers installed in multiple different buildings.

In this prior art heating system, the computers are installed in different buildings, and are connected to a cloud server via a network. Each building's heat requirements are monitored and provided to the cloud server. The heat requirements determine the number and complexity of the assigned computing tasks, and thus, based on the heat requirements, the cloud server instructs computers in specific locations to carry out computing tasks and generate heat. In this way, the heat produced by each computer can be adjusted in order to meet the heat demand of the building in that location.

There are, however, some limitations of this prior art heating system. Firstly, the prior art heating system is not portable, since installation integrates the heating system within the building. The heating system is also designed specifically for each building, and this customisation means that the prior art heating system is not reusable. Additionally, the prior art heating system is not able to scale with increased demand if required, since installation requirements typically restrict the heating system to the location of the building's previous heating system, where typically there is no further available expansion space..

It should also be noted that the prior art heating system described above is designed for and dedicated to meeting and managing one type of energy demand for a building, the heat demand. The heating system is not adaptable to meet other types of energy demand, such as electricity or computing power, or to meet more than one type of energy demand. Similarly, currently there are systems that use the heat generated by computers to meet electricity or computing power demands, but again, all existing systems are configured to meeting only one dedicated type of energy demand.

Currently available systems are unable to meet multiple energy demands for an external system (such as a building) primarily because multiple energy demands often result in conflicting operation requirements for the computers that generate the heat, and there is no way for current systems to balance these requirements..

As outlined above, it is apparent that current systems and methods that use heat produced by computers to meet an energy demand of an external system, such as the heat demand, have significant disadvantages. In particular, current systems are not scalable, portable, reusable, and are unable to meet multiple energy demands of a coupled external system.

An objective of the current invention is therefore to address at least one of the limitations outlined above.

### SUMMARY OF THE INVENTION

According to one aspect of the present invention there is provided a data processing apparatus for providing energy to an energy consuming system, the data processing apparatus comprising a portable containerised unit configured to couple to the energy consuming system in use, the portable containerised unit comprising: at least one electronic data processing device configured, in use, to process data; a cool matter stream configured to thermally couple to the at least one electronic data processing device and capture heat energy produced by the at least one electronic data processing device in use; and a load controller for controlling the at least one electronic data processing device or the cool matter stream, the load controller being configured to: receive a current energy demand parameter enabling a required energy demand of the energy consuming system to be determined; generate and send instructions that cause a change in the operation of the at least one data processing device or the flow of the cool matter stream, wherein the instructions are determined to cause a change in the temperature of the cool matter stream to meet the current energy demand parameter; and enable output of the cool matter stream to the energy consuming system, wherein the changed temperature of the cool matter stream meets at least part of the required energy demand of the energy consuming system.

Advantageously, the above data processing apparatus allows for modular expansion as multiple units can be coupled in series or parallel configuration as desired to meet required demands. Also by providing a containerised solution as is the case in some embodiments, the data processing apparatus can be customised and /or made rugged for different climates. Also this enables the data processing apparatus to be readily portable because of its size and means that installation requires minimal new infrastructure for location close to end.

The energy demand parameter may in some embodiments be a required temperature of the cool matter stream, and the load controller may be configured to determine the required energy demand using the difference between the required temperature and a current temperature of the cool matter stream.

In some embodiments, the load controller is configured to change the temperature of the cool matter stream by increasing or decreasing a clock speed of the at least one data processing device. The load controller may be configured to change the temperature of the cool matter stream by pausing or restarting operation of the at least one data processing device.

The data processing apparatus may further comprise heating circuits thermally coupled, in use, to the cool matter stream and configured, under control of the load controller to increase the temperature of the cool matter stream independently of the operation of the at least one electronic data processing device. In certain situations, the load controller may be configured to change the temperature of the cool matter stream by activating or deactivating the heating circuits and controlling the amount of data processing being carried out by the at least one electronic data processing device.

In an embodiment, the portable containerised unit comprises a plurality of modular units, each modular unit comprising an instance of the at least one electronic data processing device and the respective thermally coupled cool matter stream. Here the load controller may comprise a plurality of load sub-controllers, each load sub-controller being assigned to one of the plurality of modular units enabling independent operation of each modular unit.

The power consumption of the data processing apparatus may be varied by activating or deactivating one or more of the plurality of modular units, by changing the clock speed of the at least one data processing device, or by pausing or restarting operation of the at least one data processing device.

Advantageously the at least one data processing device may comprise a crypto-mining server. In this way a useful byproduct of the at least one data processing device can be a cryptocurrency such as Bit Coins. Also cryptocurrency generators can be readily speed up or slowed down in their processing tasks and can be interrupted for periods of time without adversely affecting the calculations they are preforming. This makes them ideal for the present embodiments.

Preferably the portable containerised unit is, in use, electrically coupled to an electrical energy generation system and the load controller is configured to: receive a current electrical energy generation level parameter regarding the energy generation system, enabling a required energy consumption of the containerised unit to be determined, and generate and send instructions that cause a change in the operation of the portable containerised unit, the instructions being determined to change the energy consumption of the portable containerised unit to meet the current electrical energy generation level parameter.

Advantageously this enables both the demands of the energy consumption source, such as a heating system, and also help to regulate an electrical energy (power) generation source by varying energy consumption of the data processing apparatus. This added utility is highly beneficial in that meets the demands of two different energy systems and reduces potential energy wastage. Another way of considering the benefits of this combination is that this embodiment minimises waste of electrical power regulation in that the computing and heat generation outputs of the system provide highly useful byproducts.

In the above embodiment the load controller is configured to change the power consumption of the at least one data processing device to meet the current electrical energy generation level parameter, by changing a rate of operation of the at least one data processing device. Alternatively or in addition the portable containerised unit is operatively coupled to an external controllable energy consumption resource, and the load controller is configured to change electrical power consumption of the containerised unit by operating the external controllable energy consumption resource. This can help to regulate the electrical energy generation system in multiple different ways. In some embodiments, the external controllable energy consumption resource is a load bank for consuming excess energy, and the load controller is configured to provide electrical energy not required by the electrical energy generation system to the load bank.

In some embodiments, the data processing apparatus further comprises an energy store configured to store electrical energy provided to the containerised unit which is not currently required by the at least one data processing device or the cool matter stream. This energy store, such as a battery, provides a buffer which can store excess electrical energy from the electrical energy generation system when the electrical energy system needs to offload electrical power (increase its electrical load) or can be used to provide energy back into the electrical energy generation system when the electrical energy generation system need to generate more electrical energy to meet demands (decrease in electrical load).

In some embodiments the load controller is configured to change the amount of electrical energy stored in the electrical energy store to meet the current electrical energy generation level parameter. Optionally, the containerised unit of some embodiments is configured to be coupled to an external electrical energy generator and the load controller is configured to activate the external energy generator and provide electrical energy generated by the external generator to meet the current electrical energy generation level parameter.

The portable containerised unit may comprise a standard-sized shipping container. Also the standard-sized shipping container may be ruggedised. As has been mentioned before this provides significant advantages over existing bespoke systems.

The present invention also extends to a method of providing energy to an energy consuming system, the method comprising: coupling a portable containerised unit to the energy consuming system; processing data using at least one electronic data processing device provided in the portable containerised unit; capturing heat energy produced by the at least one electronic data processing device using a cool matter stream thermally coupled to the at least one electronic data processing device; controlling the at least one electronic data processing device or the cool matter stream using a load controller; the controlling step comprising: receiving a current energy demand parameter enabling a required energy demand of the energy consuming system to be determined; generating and sending instructions that cause a change in the operation of the at least one data processing device or the flow of the cool matter stream, wherein the instructions are determined to cause a change in the temperature of the cool matter stream to meet the current energy demand parameter; and enabling output of the cool matter stream to the energy consuming system, wherein the changed temperature of the cool matter stream meets at least part of the required energy demand of the energy consuming system.

According to another aspect of the present invention there is provided an energy regulator for providing electrical energy to or consuming electrical energy from an electrical energy generating system and providing heat energy to a heat consuming system coupled to the energy regulator in use, the energy regulator comprising: at least one electronic data processing device configured, in use, to process data; a cool matter stream configured to thermally couple to the at least one electronic data processing device and capture heat energy produced by the at least one electronic data processing device in use; an energy store configured to store energy; and a load controller for controlling the at least one electronic data processing device, the energy store or the cool matter stream, the load controller being configured to: receive an electrical energy regulation parameter enabling a required electrical energy level of the electrical energy generating system to be determined; receive a heat energy demand parameter enabling a required heat energy demand of the heat energy consuming system to be determined; generate and send instructions that cause a change in the operation of the at least one data processing device, the energy store or the cool matter stream, wherein the instructions are determined to cause a change in the temperature of the cool matter stream to meet the required heat energy demand and/or to cause a change in the electrical energy consumed by or provided to the electrical energy generating system to regulate the electrical energy generating system to meet the required electrical energy level; and enable output of the cool matter stream to the heat energy consuming system to meet at least part of the required heat energy demand and/or electrical energy input from or output to the electrical energy generating system to meet the required electrical energy levels.

The ability of having multiple sources of electrical energy to meet the requirements of multiple different system and advantageously enables the balancing of multiple energy demands by the energy regulator.

The provision of the energy store advantageously enables decoupling of the electrical energy output and the heat energy output such that when the electrical energy and the heat energy demands are conflicting, the data processing apparatus, energy store and can cool matter stream can be controlled to meet the multiple energy demands simultaneously.

The energy store in one embodiment comprises an electrical battery and the load controller is configured to provide electrical energy from the battery to the electrical generating system to regulate the same.

The load controller may be configured to store excess electrical energy received from the electrical energy generating system, in the battery. This further helps to regulate the electrical energy generation system as excess electrical energy can be consumed by the energy regulator for use later.

In some embodiments, the energy store comprises an electrical energy generator and the load controller is configured to provide electrical energy from the electrical energy generator to the electrical energy generating system to regulate the same and/or to provide electrical energy to generate heat energy and provide the heat energy to the heat energy consuming system.

In some embodiments the heat energy demand parameter is a required temperature of the cool matter stream, and the load controller is configured to determine the required heat energy demand using the difference between the required temperature and a current temperature of the cool matter stream.

The load controller can be configured to change the temperature of the cool matter stream by increasing or decreasing a clock speed of the at least one data processing device. Also the load controller can be configured to change the temperature of the cool matter stream by pausing or restarting operation of the at least one data processing device.

In some embodiments, energy regulator further comprises heating circuits thermally coupled, in use, to the cool matter stream and configured, under control of the load controller to increase the temperature of the cool matter stream independently of the operation of the at least one electronic data processing device. The load controller may be configured to change the temperature of the cool matter stream by activating or deactivating the heating circuits and controlling the amount of data processing being carried out by the at least one electronic data processing device.

The energy regulator may comprise a plurality of modular units, each modular unit comprising an instance of the at least one electronic data processing device and the respective thermally-coupled cool matter stream. The load controller may in some embodiments comprise a plurality of load sub-controllers, each load sub-controller being assigned to one of the plurality of modular units enabling independent operation of each modular unit.

The electrical power consumption of the data processing apparatus in some embodiments can be varied by activating or deactivating one or more of the plurality of modular units by changing the clock speed of the at least one data processing device, or by pausing or restarting operation of the at least one data processing device.

Advantageously the at least one data processing device may comprise a crypto-mining server.

In some embodiments, the load controller is configured to change the power consumption of the at least one data processing device to meet the required electrical energy level, by changing a rate of operation of the at least one data processing device.

The energy regulator is in some embodiments operatively coupled to an external controllable energy consumption resource, such as a fan or a heater, and the load controller is configured to change electrical power consumption of the containerised unit by operating the external controllable energy consumption resource. In some embodiments, the external controllable energy consumption resource is a load bank for consuming excess energy, and the load controller is configured to provide electrical energy not required by the electrical energy generating system to the load bank.

The present invention also extends to a method of using an energy regulator to provide electrical energy to or consume electrical energy from an electrical energy generating system and provide heat energy to a heat consuming system, the method comprising: coupling the energy regulator to the electrical energy generating system and the heat energy consuming system; processing data using at least one electronic data processing device of the energy regulator; capturing heat energy produced by the at least one electronic data processing device using a cool matter stream thermally coupled to the at least one electronic data processing device; providing an energy store configured to store energy; and controlling the at least one electronic data processing device, the energy store or the cool matter stream, the controlling step comprising: receiving a current electrical energy regulation parameter enabling a required electrical energy level of the electrical energy generating system to be determined; receiving a current heat energy demand parameter enabling a required heat energy demand of the heat energy consuming system to be determined; generating and sending instructions that cause a change in the operation of the at least one data processing device, the energy store or the cool matter stream, wherein the instructions are determined to cause a change in the temperature of the cool matter stream to meet the required heat energy demand and/or to cause a change in the electrical energy consumed by or provided to the electrical energy generating system to regulate the electrical energy generating system to meet the required electrical energy level; and enabling output of the cool matter stream to the heat energy consuming system to meet at least part of the required heat energy demand; and/or enabling input or output of electrical energy to or from the electrical energy generating system to meet the required electrical energy level.

### BRIEF DESCRIPTION OF THE DRAWINGS

These and other features, aspects, and advantages of the present disclosure will become better understood when the following detailed description is read with reference to the accompanying drawings in which like characters represent like parts throughout the drawings, wherein:
**Figure 1** is a schematic block diagram showing a Blockbase Energy Unit according to an embodiment of the present invention coupled to an Electricity Supply Parameter Platform, a Data Processing Parameter Platform and a Heating Supply Parameter Platform;
**Figure 2** is a schematic block diagram showing the Blockbase Energy Unit of **Figure 1** in greater detail;
**Figure** 3 is a schematic block diagram showing the Load Control Platform and the data store of **Figure 2** in greater detail;
**Figure 4** is an illustration showing a perspective view of the Blockbase Energy Unit of **Figure 1****;**
**Figure 5** is a schematic diagram showing examples of input variables for the Decision Logic Engine of **Figure 3****;**
**Figure 6** is a schematic diagram showing examples of actions that can be implemented by the Control Logic Engine of **Figure 3****;**
**Figure 7A** is a flowchart showing an example of a process implemented by the Decision Logic Engine of **Figure 3****;**
**Figure 7B** is a flowchart continuing the example of **Figure 7A****;**
**Figure 8** is a flowchart showing an example of a process implemented by the Control Logic Engine of **Figure 3****;**
**Figure 9** is a schematic illustration of an example of a Swedish Frequency Response Program (FCR); and
**Figure 10** is a flowchart showing an example of a process that can be implemented by an embodiment of the present invention to execute an FCR-D Down service.

### DETAILED DESCRIPTION

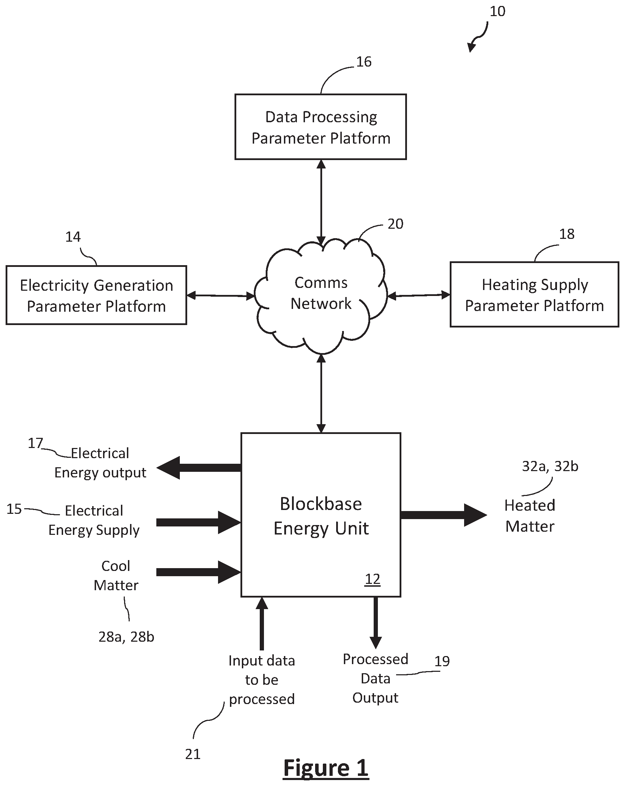

There is presented a containerised datacentre with enhanced capabilities in accordance with an embodiment of the present invention. **Figure 1** shows a schematic of a system 10 which comprises the datacentre 12, herein after referred to as a 'Blockbase' Energy Unit, and various parameter platforms. The Blockbase Energy Unit connects to the different parameter platforms via a communications network 20, which can be any wide area network, for example the internet. The parameter platforms include an electricity generation parameter platform 14, a data processing parameter platform 16, and a heating supply parameter platform 18. The electricity generation parameter platform 14 provides parameters related to the external source that is supplying energy to the Blockbase Energy Unit 12, for example, parameters could be the frequency of the electric grid, or current power consumption of the Blockbase Energy Unit 12. Whilst not shown explicitly in **Figure 1****,** it is to be appreciated that the electricity generation parameter platform 14 is operatively coupled to the external electricity supply source 15 to determine the electricity supply parameters. The data processing parameter platform 16 provides parameters relating to processed data 19 that is output from the Blockbase Energy Unit 12, and parameters relating to the external data processing source to which the processed data may be provided. For example, a parameter could be HPC revenue. Whilst not shown explicitly in **Figure 1****,** it is to be appreciated that the data processing parameter platform 16 may be operatively coupled to other external data processing sources (such as other Blockbase Energy Units 12) to determine the data processing parameters for the present Blockbase Energy Unit 12. The heating supply parameter platform 18 provides parameters related to an external utility system that may be connected to the Blockbase Energy Unit 12, and the heated matter 32a, 32b produced by the Unit 12. The external utility system could be, for example, a district heating system (a system for heating a plurality of dwellings in a district), and examples of parameters on the heating supply parameter platform 18 may be required heat value (unit/kWh) or required heat production (kWh) of the Blockbase Energy Unit 12. The Blockbase Energy Unit 12 uses parameters obtained from these platforms to control the unit's outputs 17, 19, 32a, 32b. Whilst not shown explicitly in **Figure 1****,** it is to be appreciated that the heating supply parameter platform 18 is operatively coupled to the external heating utility system (not shown) to determine the heating supply parameters.

The outputs which the Blockbase Energy Unit 12 can generate are shown in **Figure 1** as heated matter (such as heated fluid 32a and/or heated air 32b), electrical energy 17 and processed data 19. As inputs the Blockbase Energy Unit 12 receives cool matter (such as cool fluid 28a and/or cool air 28b) as well as an electrical energy supply 15. The Blockbase Unit 12 can also optionally receive data to be processed 21 as an input. The Blockbase Energy Unit 12 can control the consumption of energy to increase or reduce demand on the external electrical system providing the electrical energy. For example this can be in the form of FCR-D up or down responses as is explained later. Also, the Blockbase Energy Unit 12 can store energy and either release this or use the stored energy to generate other forms of energy, when required as an output. For example electrical energy can be stored and used at the appropriate time to generate heat energy for output.

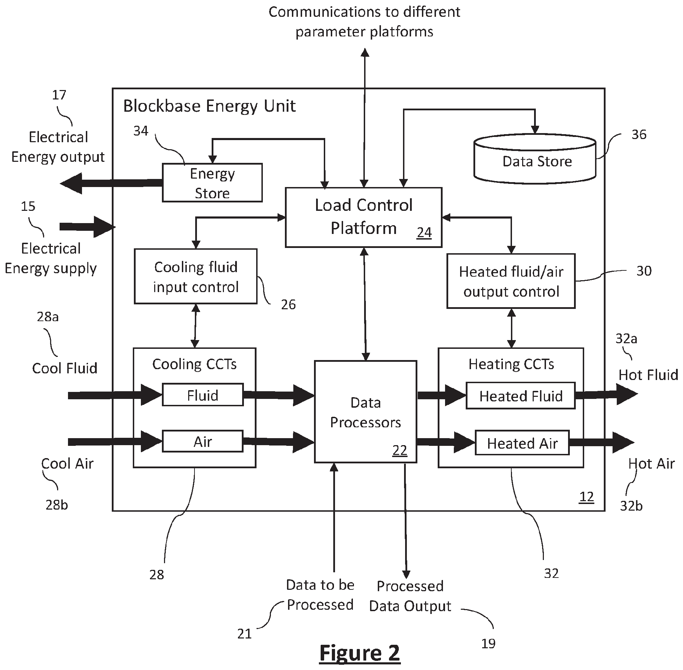

The Blockbase Energy Unit 12 is shown schematically in greater detail in **Figure 2****.** The Blockbase energy unit comprises data processors 22, cooling CCTs 28, and optionally heating CCTs 32. The cooling CCTS 28 and heating CCTs 32 communicate with and are controlled by a cooling fluid input control 26 and a heated fluid/air output control 30 respectively. These control units 26, 30, and the data processors 22, are connected to a Load Control Platform 24. The Blockbase Energy Unit 12 additionally comprises an energy store 34 and a data store 36, both of which also connect to the Load Control Platform 24.

The Blockbase Energy Unit 12 comprises a Heating Source, a Cooling/Heat Capturing Device and a controller. The data processors 22 are used as the heating source, and these turn electrical energy 15, which is an input of the Blockbase Energy Unit 12, into heat. In one embodiment, the data processors 22, and thus the heating source, are crypto mining servers. These can, in some embodiments, be manufactured by companies such as Bitmain, MicroBT/Whatsminer. This is a particularly useful embodiment as the rate of completing the processing task can be varied without affecting the result of the processing outcome. The principle of operation of the Blockbase Unit 12, however, also works with other data processing devices which generate heat such as standard computer servers or HPC devices that consume electricity. Processed data 19 can usefully be output from the data processors 22 as a result of their operation.

The cooling CCTs 28 and heating CCTs 32 within the Blockbase Energy Unit 12 act together as heat capturing/generating devices. The cooling CCTs 28, under control of the cooling fluid input control 26, receive cool matter as an input. This cool fluid 28a and cool air 28b captures excess heat from the data processors 22, essentially fluid cooling them. The resultant hot fluid 32a and hot air 32b may then be passed to the heating CCTs 32, which are under the control of the heated fluid/air output control 30. The heated fluid/air output control 30 controls the output temperature of the fluid to an external heating utility system and where required can increase the temperature of the output fluid 32a. The heated fluid/air output control 30 also controls the release of the hot fluid/air, either to the external utility heating system, such as a district heating system, or in the case where the external utility heating system does not require the hot fluid/air, the hot fluid/air is cooled to ensure there is enough coolant to capture the heat produced by the data processors 22.

The Load Control Platform 24 communicates with the cooling fluid input control 26, the heated fluid/air output control 30, and the data processors 22 to provide instructions on operation of the respective components. The Load Control Platform 24 also communicates with each of the parameter platforms 14, 16, 18 to receive input parameters, and with the energy store 34 and the data store 36. The energy store 34, which can be provided by a suitable battery in some embodiments, stores electrical energy that has been provided to the Blockbase Energy Unit 12 but has not been used by the data processors 22 in performing their tasks (the amount consumed by the data processors 22 can be increased or decreased). The stored energy can then be provided as an electrical energy output 17 when required to meet an increased electrical energy demand or can be used as an energy source to increase the data processing or generate a greater amount of heat (either using heaters or by increased operation of the data processors) to meet data computing demands or increased heating demands. In this regard, it is to be appreciated that the energy store 34 effectively decouples the electrical energy output 17 from the heated matter output 32a, 32b such that the Blockbase unit 12 can operate independently to meet simultaneous conflicting output demands. In other words, the provision of the energy store 34 advantageously enables independent operation of the Blockbase unit 12 to provide multiple simultaneous energy outputs, even if those outputs would normally require incompatible ways of operating the Blockbase unit 12.

As mentioned above, the provision of the energy store 34 advantageously enables simultaneous, possibly conflicting demands of the different external utility systems to be accommodated as the energy source 34 enables decoupling of the conflicting simultaneous demands. For example, consider the heat demand of an external heating utility system and the frequency requirements for the external power supply system running a regional/national electrical power supply grid, providing electrical energy 15 to the Blockbase Energy Unit 12. If the external heating utility system is found to have a reduced heat demand, but at the same time the frequency of the electricity from the external electrical system is found to be too high, the data processors 22 must carry out two opposing operations: a reduced heat demand requires a reduction in power consumption of the data processors 22, while an increase in power consumption of the Blockbase Energy Unit 12 is required to reduce the frequency of the electricity provided by the external electrical system. To meet both the electricity and heat requirements, the data processors 22 reduce their power consumption (and thus reduce the amount of heat produced and provided to the external heating utility system) and the energy store 34 is charged by the electricity supply 15. Charging the energy store 34 increases the power consumption of the Blockbase Energy Unit 12, and thus the frequency of the electrical energy provided by the external electrical energy system is reduced. Using the energy store in this way is only required when there are conflicting demands. Another way of meeting these conflicting demands would be to direct excess heat produced by the data processors 22 (but not required by the external heating utility system) over the cooling circuits 28 within the Blockbase Energy Unit 12. Of course, if the demands are complementary then both can be accommodated with either minimal (to precisely match demands) or no use of the energy store 34. For example, if the energy consumption in the above example, was to be reduced (reduced input electrical energy 15) to increase a frequency response of the electrical energy supply system, then the decreased electrical consumption of the Blockbase unit 12 for the data processors 22 could be realised by consuming less energy from the electrical supply 15.

Whilst not shown in Figure 2, the Blockbase Energy unit 12 can also optionally be coupled to an external controllable energy consumption resource, such as an electrical heater to also help decouple possibly conflicting demands of the different external utility systems. This is used when the electrical power consumption of the Blockbase Energy Unit 12 is to be increased to reduce frequency of the electrical grid to which the Blockbase Energy unit 12 is connected. Similarly, whilst not shown in Figure 2, the Blockbase Energy unit 12 can also optionally be coupled to an external controllable energy generation resource, such as an electrical generator (gen-set - typically which uses a fossil fuel engine to generate electricity) to also help the decoupling mentioned above. This is used when the electrical power consumption of the Blockbase Energy Unit 12 is to be reduced and electrical power is to be provided back into the electrical grid to increase the frequency of the electrical grid to which the Blockbase Energy unit 12 is connected.

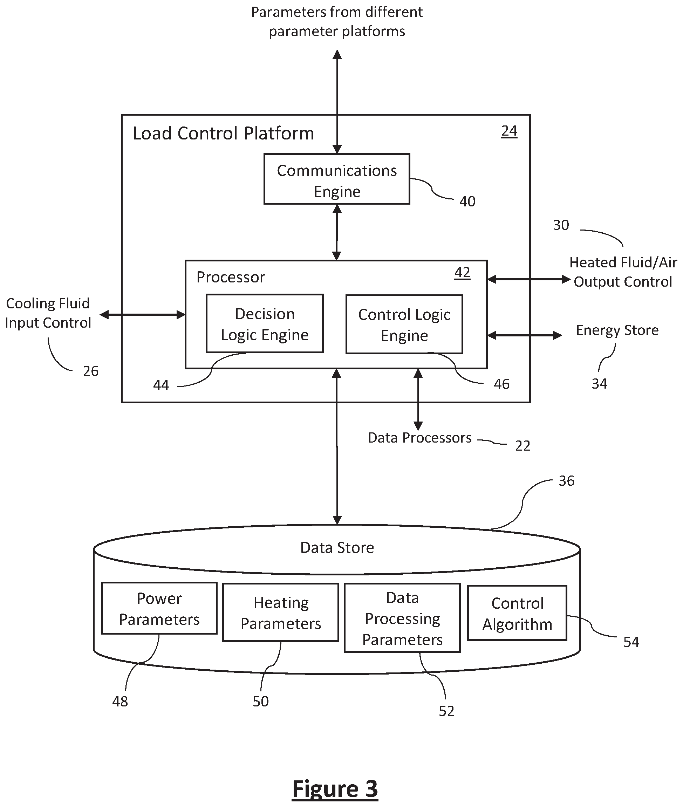

A schematic diagram of the Load Control Platform 24 and the data store 36 is shown in greater detail in **Figure 3****.** The Load Control Platform 24 comprises a communications engine 40 connected to a processor 42. The processor comprises a Decision Logic Engine 44 and a Control Logic Engine 46. The Decision Logic Engine 44 receives parameters from each of the different parameter platforms 14, 16, 18 via the communications engine 40. These parameters, such as power parameters 48, heating parameters 50, and data processing parameters 52 are stored in the data store 36. The data store 36 also contains a control algorithm 54 which is used to configure the operation of the Decision Logic Engine 44 and the Control Logic Engine 46.

Decisions made by the Decision Logic Engine 44 are implemented by the Control Logic Engine 46, which communicates data processing and/or configuration instructions to the data processors 22 (for example configuration instructions may include changing the clock speed of the processors). The processor 42 of the Load Control Platform 24 is also responsible for communicating with the energy store 34 and sending instructions and receiving feedback from the cooling fluid input control 26 and the heated fluid/air output control 30. The Load Control Platform 24 is a central component and acts to control the entire Blockbase Energy Unit 12. For example, the Load Control Platform 24 can make decisions on how to increase and decrease outputs (heated matter 32a, 32b, electrical energy 17 and processed data 19) in response to received parameters, as well as how the resultant increase in required input energy is to be obtained (from the electrical input supply 15 or from the on-board energy store 34). Examples of this decision making by the Load Control Platform 24 are described later.

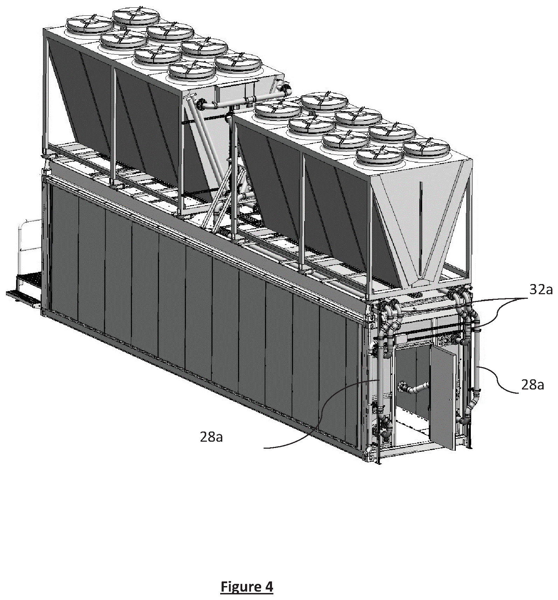

**Figure 4** shows a perspective view of the containerised Blockbase Energy Unit 12. The containerised solution has multiple associated advantages. For example, the containerised solution:
(i) allows for modular expansion as multiple units can be coupled in series or parallel configuration as desired to meet required demands;
(ii) can be customised / made rugged for different climates (for example, the Blockbase Energy Unit 12 is suitable for climates where there are strong rains and winds, high and low temperatures, and snowfall since it is an entirely containerised system)
(iii) is portable because of the size of the unit (the Blockbase Energy Unit 12 is built using a standard shipping container sized unit, for example, using the dimensions of the most common 40ft shipping container, the size of the unit may be approximately 12.0 x 2.3 x 2.4 metres) and ruggedised in nature, which enables the Blockbase Energy Unit 12 to be reused and redeployed as required (readily transportable via a tilt-back truck for example), because the unit 12 is not a bespoke solution to a given installation; and
(iv) requires minimal new infrastructure for location close to end users. Location can be important if the generated heated fluid is to be used as an input to an external utility heating system as proximity to the district heating system reduces heat loss and thereby increases efficiency.

The Blockbase Energy Unit 12 of this embodiment is comprised of two modular operational sides, a left side and a right side, where each side consumes approximately 1.2 MW of power. Each side replicates the data processors 22, the cooling and heating circuits 28, 32, and the cooling fluid input control 26 and the heated fluid/air output control 30 shown in Figure 2. However each modular operational side works independently of the other, meaning different logic and settings can be applied to each side within the Blockbase Energy Unit 12 to control power consumption very accurately and in a highly responsive manner. The load controller (load control platform 24) can in this embodiment be comprised of two sub-controllers, each independently controlling a different modular operational side. Accordingly, the power consumption of the unit 12 in this embodiment can be precisely varied from 0.02MW to 2.4MW (minor power usage is required for the control electronics) almost instantaneously and certainly within required time limits specified, for example, in a frequency response (energy regulation) specification. The Blockbase Energy Unit 12 can also consume more power depending on the configuration of the internal devices, for example by increasing the clock rate of the data processors 22, storing unused electrical power in the energy store 34 or activating the heating circuits to generate a higher-temperature heated fluid output 32a.

It is to be appreciated that in this embodiment there can be a temperature variation (Delta) of up to 15°C between the input cool water 28a and output hot water 32a, and a maximum output temperature of around 60°C. The output hot water can be provided to, for example, a district heating system. The temperature variation and maximum output temperature can change depending on the computing hardware used inside the container. If it is desired to output a higher temperature than 60°C, the Blockbase Energy Unit 12 can optionally provide additional external heating devices 32 to boost the temperature of the heated water/fluid 32a to approximately 85°C. Examples of additional external heating devices 32 that can be used in other embodiments include heat pumps, electric boilers and flow heaters. These heating devices 32 can then also be used in the power control for a frequency response application if desired, with their degree of activation controlling the degree of consumption of power for example.

The present embodiment can be used to provide multiple services, for example, Energy Frequency Response, providing hot water from waste heat, energy trading, computing power for HPC applications, and/or Blockchain workloads. The provision of an energy store 34 decouples the different energy supplies provided by the Blockbase Energy Unit 12. This enables the demands of multiple services to be accommodated at the same time even if those demands are conflicting as has been explained above.

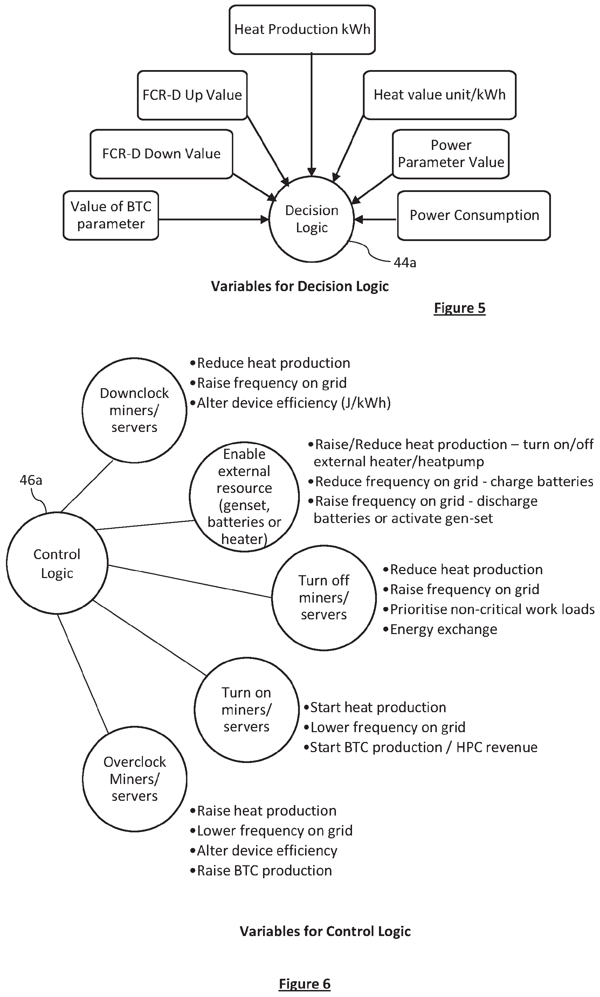

To manage the services that the Blockbase Energy Unit 12 can provide, and to control the Unit 12 itself, a Load Control Service is used. This is an automated program consisting of two parts: Decision Logic 44a (implemented by the Decision Logic engine 44) and Control Logic 46a (implemented by the Control Logic engine 46). **Figures 5** and **6** show the variables that can be managed, by Decision Logic 44a and Control Logic 46a respectively.

Decision Logic 44a makes decisions based on input parameters, calculations, and specifications. Examples of input parameters are shown in **Figure 5****,** and include BTC parameter value, FCR-D down or FCR-D up value, heat production, heat value, power parameter value, and power consumption. The Decision Logic Engine 44 reads these parameters via the multiple parameter platforms 14, 16, 18. Calculations and specifications that are taken into account by Decision Logic 44a include the features available at certain locations, for example, if waste heat provision is possible, if the hardware is FCR-D compatible, or if additional external add-ons like batteries are available, amongst others.

The Decision Logic 44a constantly queries the external sources (electricity supply, district heating system, for example) for changes in input parameter values. Depending on how often the source's values can change, the Decision Logic 44a can query data from below one second to just once a day. This is useful in frequency response programs, as each individual frequency response program requires different response times. The Blockbase Energy Unit 12 can be configured to meet the requirement of each program.

In one non-limiting example, the Decision Logic 44a for a Swedish frequency response program FCR-D needs to read frequencies with 10 MHz resolution. The response time for FCR-D is 50% of the load within 5 seconds, and the rest of the load (50%) has to be responded to within 25 seconds. Therefore, 100% of the load needs to be responded to in a maximum time of 30 seconds.

There are other frequency response programs like FFR which need response times between 0.7 and 1.3 seconds, and the Blockbase Energy Unit 12 can be configured to meet these response times. In general, there are different programs for frequency response within a particular country, like Sweden, and other countries have other programs and requirements. The values above are examples for the Swedish frequency control program.

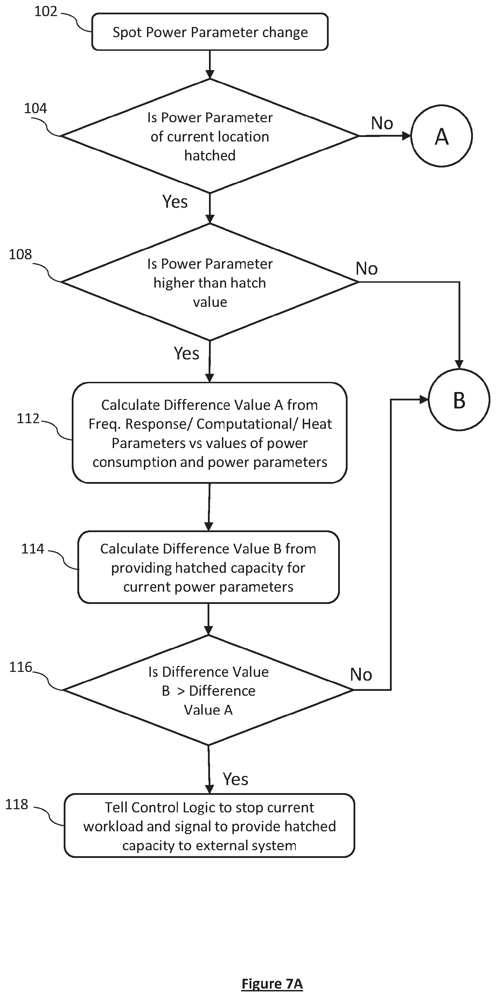

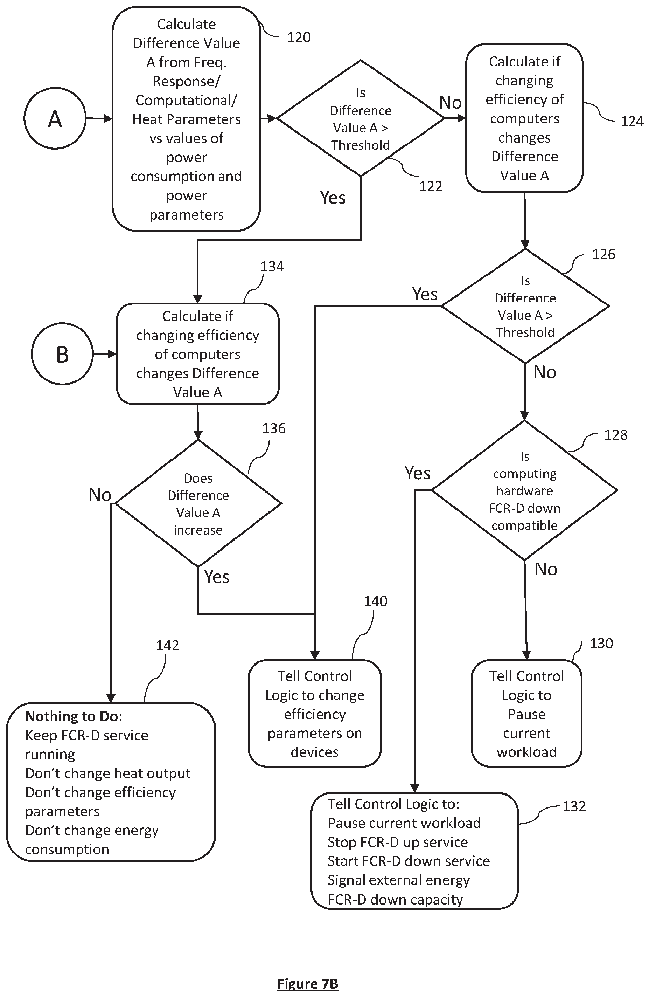

An example of Decision Logic 44a is depicted in the flowcharts in **Figure 7A** and **7B****,** which demonstrate how a change in power parameter value can cause different outcomes (i.e. instruct the Control Logic 46a to action different scenarios). The power parameter may be power price, power demand, or any other suitable parameter.

In this example the term 'hatched' is used and refers to a parameter value that is 'locked' or 'fixed' in accordance with a predetermined requirement or agreement, namely stable. If such a predetermined requirement or agreement is not in place, then the value of the parameter can vary significantly over time (has high volatility). This would therefore negatively impact energy output generation, which makes decisions based on these parameter values.

The Decision Logic 44a process illustrated in **Figure 7A** commences when the Decision Logic 44a detects, at Step 102, a change in the value of a power parameter. The Decision Logic 44a then determines, at Step 104, if the power parameter of the current location is hatched.

If the power parameter is not hatched, the process continues at Point A which leads to calculating, at Step 120, a Difference Value A: this pathway is illustrated in **Figure 7B** and is detailed below. If the power parameter is hatched, the Decision Logic 44a then determines, at Step 108, if the power parameter is higher than the hatch value. If the power parameter is not higher than the hatch value, the process continues at Point B which leads to calculating, at Step 134, if changing efficiency changes the Difference Value A (this pathway is also illustrated in **Figure 7B** and described below). Otherwise, the Decision Logic 44a calculates, at Step 112, the Difference Value A from frequency response parameters, computational parameters and heat parameters, versus the power consumption value and power parameter value. Difference Value A is the power parameter difference value. In one non-limiting example, where the power parameter is price, Difference Value A could be profitability (and thus is calculated as the difference between the income generated from frequency response, the computational processes and heat provided to external utility systems compared to the cost of power consumption and power price).

The Decision Logic 44a then calculates, at Step 114, Difference Value from providing hatched capacity for current power parameters. In this example, Difference value B is also a power parameter difference value. In the above non-limiting example where the power parameter is price, Difference Value B could also be profitability, and would be the profitability resulting from selling the hatched capacity for the current power prices.

The Decision Logic 44a then determines, at Step 116, if Difference Value B is greater than Difference Value A. If Difference Value B is not greater than Difference Value A, the process continues at Point B which leads to calculating, at Step 134, if changing efficiency changes the Difference Value A (**Figure 7B**), and this pathway is described below. If Difference Value B is greater than Difference Value A, the Decision Logic 44a instructs, at Step 118, the Control Logic 46a to stop the current workload, and to provide, the hatched capacity to the external utility system. In this example, where the hatched parameter is electrical power, returning the remaining amount of the hatched parameter to the source of that power is a form of energy trading. This is one outcome of the Decision Logic 44a identifying a change in a power parameter.

**Figure 7B** shows alternative pathways and resulting actions of the Decision Logic 44a in response to a change in a power parameter. After Step 104, where the Decision Logic 44a determines that the power parameter is not hatched, Difference Value A is calculated, at Step 120, using the same method as Step 112. Then, the Decision Logic 44a determines, at Step 122, if the Difference Value A is greater than a Threshold. The Threshold is a chosen value, where a Difference Value above this value offers an advantage to the Blockbase Energy Unit 12. For example, the Threshold could be the threshold for efficiency, profitability, or any other suitable value which is dependent on the power parameter. If the Difference Value A is not greater than the Threshold, the Decision Logic 44a calculates, at Step 124, if changing the efficiency of the computers (data processors 22) changes the Difference Value A. The Decision Logic 44a then checks, at Step 126, if the Difference Value A is now greater than the Threshold, and if so, the Decision Logic 44a instructs, at Step 140, the Control Logic 46a to change the efficiency parameters on the data processors 22. This is a second possible outcome of the Decision Logic 44a identifying a change in power parameter.

If, at Step 126, the Difference Value A is not greater than the Threshold, the Decision Logic 44a checks, at Step 128, if the computing hardware is FCR-D down compatible. If the hardware is not compatible, the Decision Logic 44a instructs, at Step 130, the Control Logic 46a to pause the current workload, which is a third possible outcome of identifying a change in power parameter. If the hardware is found, at Step 128, to be FCR-D down compatible, the Decision Logic 44a instructs, at Step 132, the Control Logic 46a to pause the current workload, stop the FCR-D up service, start the FCR-D down service, and to signal the external energy FCR-D down capacity. This is a further potential outcome of the Decision Logic 44a identifying a change in power parameter.

If the Difference Value A is found, at Step 122, to be greater than the Threshold at this stage, of the Blockbase Energy Unit 12 calculates, at Step 134, if changing the efficiency of the computers (data processors 22) changes Difference Value A. Step 134 is also completed after Step 108, if the power parameter is not higher than the hatched parameter, and after Step 116, if Difference Value B is not greater than Difference Value A. After Step 134, the Blockbase Energy Unit 12 determines, at Step 136, if Difference Value A increases due to changing the efficiency of the computers. If Difference Value A increases, the Decision Logic 44a instructs, at Step 140, the Control Logic 46 to change the efficiency parameters on the data processing devices 22. Otherwise, there is nothing to do, and all operation parameters are maintained at Step 142. Thus, it can be appreciated that various outcomes are possible from the Decision Logic 44a identifying a change in the value of a power parameter.

Although this example shows a specific implementation of Decision Logic 44a that occurs when a change in the value of a power parameter 48 is observed, similar Decision Logic flows are or can be implemented for other changes that occur on the input side. For example, changes in the value of heating parameters 50 or the value of data processing parameters 52.

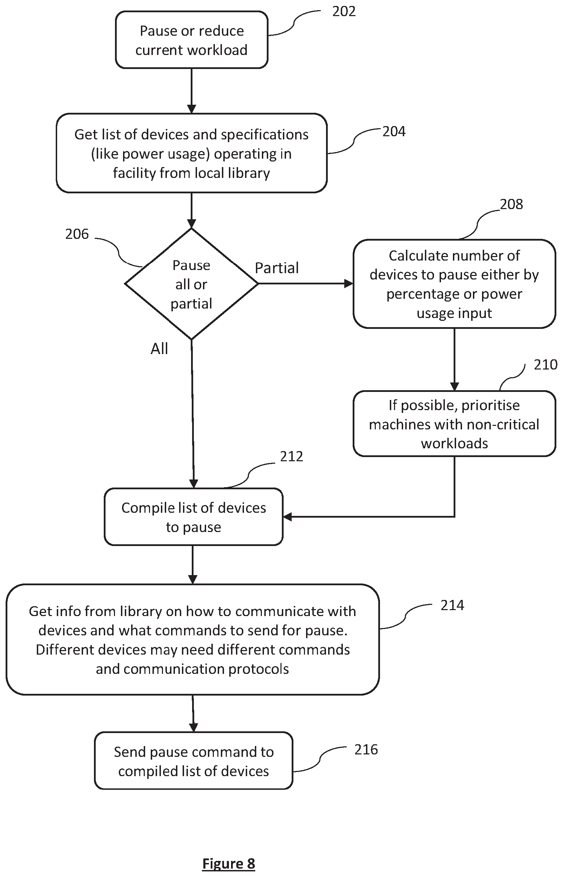

As briefly outlined, Decision Logic 44a instructs Control Logic 46a to carry out certain operations on different devices. Control Logic 46a interacts and communicates with hardware devices like computers, as well as external devices like generators or battery add-ons. The Control Logic 46a can take various actions as shown in **Figure 6****.** For example, the Control Logic 46a can raise the power consumption of these data processing devices 22 by overclocking them, or lower power consumption by downclocking them or instructing them to pause their workloads. An example of a process implemented by the Control Logic 46a, where the Control Logic has received an instruction to pause or reduce the current workload, is shown by the flowchart in **Figure 8****.**

The process commences after receiving, at Step 202, an instruction from the Decision Logic 44a to pause or reduce the current workload. The Control Logic 46a then retrieves, at Step 204, a list of the devices (data processors 22) that are operating in the facility, together with their technical specifications, from a local library stored in the data store 36. The Control Logic 46a then determines, at Step 206, if all devices should be paused, or if only a partial pause is required. This is dependent on how much the power consumption needs to be reduced by to meet the requirements defined by the change in external parameter. If only a partial pause is required, the Control Logic 46a calculates, at Step 208, the number of devices to pause either as a percentage, or as a power usage input. Once this has been calculated, the Control Logic 46a selects, at Step 210, which devices are to be paused and prioritises devices with non-critical workloads if this is possible. The Control Logic 46a then compiles, at Step 212, a list of the devices that should be paused. If it was determined at Step 206 that all devices should be paused, the Control Logic 46a compiles, at Step 212, a list containing all of the devices in the facility. The Control Logic 46a then retrieves, at Step 214, information specifying how to communicate with each device, and the commands that are required to pause the devices on the compiled list from the local library. Step 214 is required as different devices may need different commands and communication protocols. Once this information is received the Control Logic 46a sends, at Step 216, the pause command to the compiled list of devices. This flowchart illustrates an example of the Control Logic 46a after receiving an instruction to pause or reduce the current workload. It is to be appreciated that similar processes are possible when the Control Logic 46a receives different instructions, for example to raise heat production, or to alter the efficiency of the data processors 22.

As discussed, the Control Logic 46a is responsible for instructing the data processors 22, that are part of the Blockbase Energy Unit 12. Various types of data processing can be used, for example crypto mining. The advantages of using this type of data processing include:
- A very high-power density is possible. This means that high power demand is available on a very small footprint which makes crypto mining ideal for a containerised embodiment.
- The mining process can be interrupted at any time without losing any state or data, which makes crypto mining highly suitable for frequency response programs, where devices may need to be paused to balance the electric grid frequency.
- The mining process generates instant revenue without the need of contracted customers / contracts or services.
- The high-power density of the machine allows a great range of power control. This means that the Blockbase Energy Unit 12 can operate single crypto miners in a range from 0 to 10 kW (this is just an example of one type of machine that can be used). This Power consumption can vary greatly depending on the machine that is used. The present disclosure covers the use of a variety of different crypto mining machines.

Another example of the type of data processing that can be carried out is any form of HPC. This type of data processing is ideally suited to deliver frequency response functionality of an embodiment of the present disclosure. The advantages include:
- A very high energy density, that can be varied, is possible. This means that the quantity of power used can be reduced or raised precisely.
- A low reaction time, where specialised software and hardware is provided to enable fast reactions, which is essential to react to frequency changes in the electric grid.
- A high geographic flexibility, thus the Blockbase Unit 12 can be located and operate anywhere.
- A low cost of reacting, meaning that subject to the application/workload, HPC can operate periodically.
- A high availability, as typically such computing operates 24 hours per day. This means that a frequency response functionality can operate 24 hours a day, which essential to continuously maintain electric grid frequencies within safe limits.

There are many applications of the Control Logic 46a of the described embodiment of the invention, but as outlined above, one application in which HPC is a particularly suitable type of data processing, is providing Electric Grid Frequency Response functionalities. Frequency Response Programs may vary between countries and have different names, but the core principle remains the same: to balance the electric grid and react to frequency changes. The solution provided by the described embodiment of the invention can be adapted to fit the various requirements between countries.

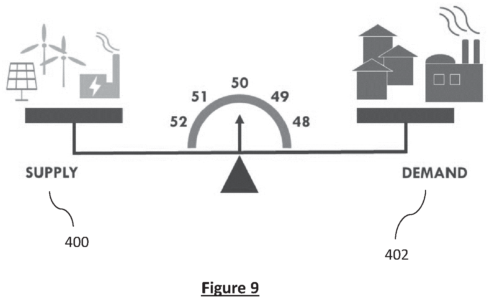

Discussed below is an example of the Swedish Frequency Response Program, named FCR and the requirements of the FCR. This is also shown schematically at a high level in **Figure 9****.**

The electrical output of the electricity supply 400 in this Response Program must always match electricity demand 402. If there is an insufficient supply 400 of electricity, this results in a frequency drop of the output alternating power supply typically below a 50Hz standard of an electrical supply (though in some countries like the USA this can be 60Hz), and the extra energy required is then taken from spinning a mass of generators. If there is a surplus supply 402 of electricity compared to the demand, the result will be a frequency increase of the output alternating power supply, as energy is transferred to the spinning mass of generators. Frequencies that are too high or too low from the desired standard level (such as 50Hz) can be harmful to equipment and the power supply system, which may result in wide-spread black outs. Operating the power supply system therefore is a constant balancing act, where a stable frequency is a key indicator of a stable power supply. Various frequency reserves, for example FCR-D (frequency containment reserves for disturbances), ensure that frequency deviations are contained, minimized and restored. These reserves play a key role in stability of the power supply system and are essential for operation of the power supply system.

FCR-D is a reserve intended to contain the frequency during any disturbances. FCR-D ensures that frequency drops are limited during extensive frequency drops outside of normal operating limits (i.e. below 49.9 Hz). This can happen, for example, if a generator fails unexpectedly. In such a situation, participants of the FCR program react to balance the generation and load, by increasing production, or decreasing demand of electricity. SVK (Svenska Kraftnät) operates the FCR-D market that employs third parties to use their technical resources to react to these emergency situations.

FCR-D up refers to upregulation, which is activated in the frequency range 49.90-49.50 Hz. Increasing the frequency requires a reduction of power consumption, for example, in the present embodiment where the Blockbase Energy Unit 12 is providing FCR-D functionality, the Unit 12 can downclock or turn off devices to consume less electrical power, or discharge stored electrical charge from the energy store 34 (e.g. batteries) to the electric grid, to provide more electrical power to the power supply system.

FCR-D down refers to downregulation, which is activated for example in the frequency range 50.1-50.5 Hz when the required output level is 50Hz. Decreasing the frequency requires an increase in power consumption, for example, in the present embodiment the Blockbase Energy Unit 12 can overclock devices or charge the energy store 34 (e.g. batteries). Also, if there is a simultaneous demand for increased heat output, the Blockbase Energy Unit 12 can consume more electricity by activating the heating circuits 32.

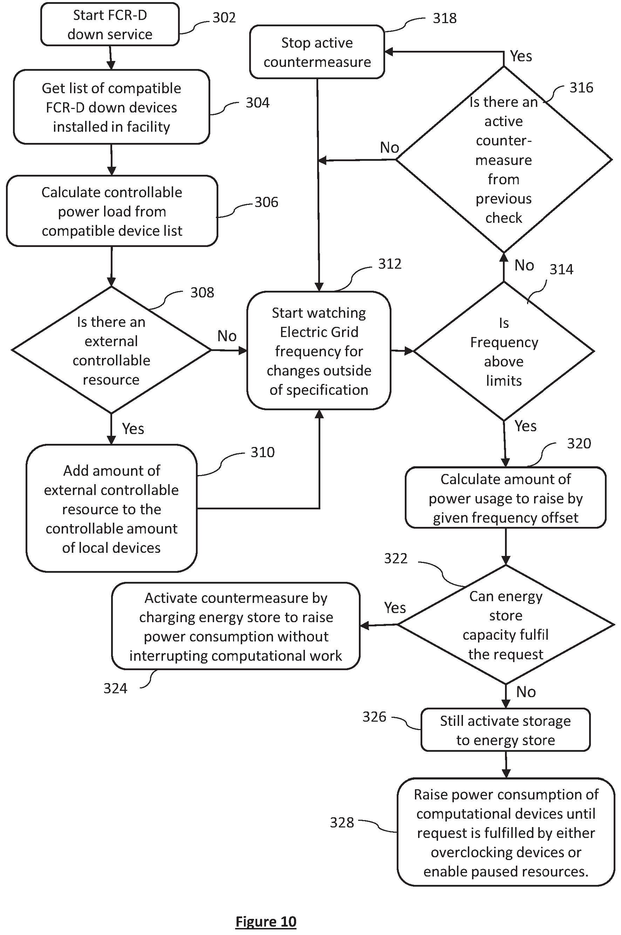

An example of how the Blockbase Energy Unit 12 of an embodiment of the present invention can be configured by the Decision Logic 44a and Control Logic 46a to implement an FCR-D Down service is shown in **Figure 10****.** This process helps to stabilise the electric grid in the case where the frequency goes above a certain threshold.

The process commences at Step 302 when FCR-D down service starts. The Blockbase Energy Unit 12 retrieves, at Step 304, a list of compatible FCR-D down devices that are installed in or operably connected to the Blockbase Energy Unit 12 from the data store 36, before calculating, at Step 306, the controllable power load from the compatible device list. The Blockbase Energy Unit 12 then determines, at Step 308, if there is an external controllable resource in addition to the energy store 34 within the Blockbase Energy Unit 12. In some embodiments, additional external controllable resources such as batteries or generators (not shown) can be coupled to the Blockbase Energy Unit 12. If there is an external controllable resource, the Blockbase Energy Unit 12 adds, at Step 310, the controllable power load of the external resource to the controllable amount of the local devices (such as the energy store 34, the data processors 22 and the heating circuits 32), and then the Blockbase Energy Unit 12 starts to watch, at Step 312, the Electric Grid frequency for changes outside of known acceptable limits (this information can be provided by the Electrical Generation Parameter Platform 14 and stored in the datastore 36). If there was no external controllable resource available at Step 308, the Blockbase Energy Unit 12 moves to Step 312 directly.

While watching the electric grid, the Blockbase Energy Unit 12 queries, at Step 314, if the frequency of the Electric Grid is above the acceptable limit. It should be appreciated that the rate at which the Blockbase Energy Unit 12 queries the electric grid can change and is dependent on electricity markets at that time. For example, in Sweden for FCR the maximum query time is 200ms. If the frequency of the Electric Grid is not above the acceptable limit, the Blockbase Energy Unit 12 then verifies, at Step 316, if there is an active countermeasure in place from the previous check, and if there is no countermeasure in place, the Blockbase Energy Unit 12 repeats Steps 312 to 316. If however, an active countermeasure is found to be in place at Step 316, the Blockbase Energy Unit 12 then stops, at Step 318, the active counter measure. Again, Steps 312 to 318 are repeated in a loop, continuously checking the Electric Grid frequency for changes outside of normal limits.

If the frequency is found, at Step 314, to be above the acceptable limits, the Blockbase Energy Unit 12 calculates, at Step 320, the amount the power usage needs to increase by to decrease the frequency back to within normal limits. The Blockbase Energy Unit 12 then determines, at Step 322, if the energy store 34 capacity (such as batteries) alone can fulfil the request. If the energy store 34 capacity is sufficient, a countermeasure is activated at Step 324 to, for example, charge batteries and thus raise power consumption without interrupting computational work of the data processors 22. If however, the available capacity of the energy store 34 alone cannot fulfil the request, the energy store 34 is still activated at Step 326, and then the Blockbase Energy Unit 12 raises, at Step 328, the power consumption of the computational devices (processors 22) until the request is fulfilled. This is done by either overclocking the devices, or by enabling any paused devices. In embodiments where there is also an external controllable resource, the Blockbase Energy Unit can instruct the external resources to raise their power consumption. For example when additional external batteries are available, the Blockbase Energy Unit can charge the external batteries.

As briefly described previously, a further application of this embodiment of the invention is Energy Trading. If a current energy demand parameter is above a threshold associated with the Blockbase Energy Unit 12 per unit of power consumed, the electricity capacity can be offered back to the grid. This could be enhanced by utilising the energy store 34 or external batteries to charge during lower power cost hours and discharging at peak power cost hours. Alternatively, a power generation device (thermal or renewable) could be utilised to supply electricity to the grid. The Energy Trading process is managed automatically by the Load Control Service 44a, 46a.

As described briefly above, in an embodiment the Blockbase Energy Unit comprises all of the features described above and illustrated in **Figure 2** and additionally comprises, alongside the internal energy store 34, an external energy store 34, which is also in communication with the Load Control Platform 24. As described, an external energy store allows for an increased capacity, which is advantageous in frequency regulation and energy trading applications.

In some embodiments of the present invention, the Blockbase Energy Unit 12 comprises all of the features described above and illustrated in **Figure 2****,** except the internal energy store 34 is external to the Blockbase Energy Unit 12. While an internal energy store 34 allows for the Blockbase Energy Unit 12 to be modular, which in itself provides numerous advantages, an external energy store 34 (e.g. battery) may be advantageous as the external energy source allows an energy store 34 of increased size and thus capacity to be used. An increased amount of energy can therefore be stored and is available to the Blockbase Energy Unit 12 when required to meet increased electrical energy demands, computing demands, or heating demands. Thus, in some embodiments, the Blockbase Energy Unit 12 is not modular.

In some specific use application embodiments, the Blockbase Energy Unit 12 may not perform regulation of the electrical energy generation supply and may just be focussed on providing a portable controllable energy unit for providing heat energy to a heat energy consuming system. In this case, such a specific use embodiment comprises all of the features illustrated in **Figure 2** apart from an energy store 34. This embodiment of the Blockbase energy Unit 12 may provide portable heating to any location, which in itself offers many advantages over known solutions.

In a further embodiment, the Blockbase Energy Unit 12 comprises all of the features illustrated in **Figure 2** apart from heating circuits 32. In this embodiment, where there are no heating circuits, the cool matter 28 captures the heat generated by the data processors 22, which increases the temperature of the cool matter 28. There is no option to increase the temperature of the hot fluid 32a or hot air 32b further, but the heat generated by the data processors 22 may be sufficient to provide energy to external utility systems in some applications. This embodiment results in a slightly simpler design for the Blockbase unit 12 which is suitable in some situations.

While the embodiments set forth in the present disclosure may be susceptible to various modifications and alternative forms, specific embodiments have been shown by way of example in the drawings and have been described in detail herein. However, it should be understood that the disclosure is not intended to be limited to the particular forms disclosed. The disclosure is to cover all modifications, equivalents, and alternatives falling within the spirit and scope of the disclosure as defined by the following appended claims.

The techniques presented and claimed herein are referenced and applied to material objects and concrete examples of a practical nature that demonstrably improve the present technical field and, as such, are not abstract, intangible or purely theoretical. Further, if any claims appended to the end of this specification contain one or more elements designated as "means for [perform]ing [a function]..." or "step for [perform]ing [a function]...", it is intended that such elements are to be interpreted under 35 U.S.C. 112(f). However, for any claims containing elements designated in any other manner, it is intended that such elements are not to be interpreted under 35 U.S.C. § 112(f).

## Claims

1. An energy regulator for providing electrical energy to or consuming electrical energy from an electrical energy generating system and providing heat energy to a heat consuming system coupled to the energy regulator in use, the energy regulator comprising:
at least one electronic data processing device (22) configured, in use, to process data;
a cool matter stream (28a, 28b) configured to thermally couple to the at least one electronic data processing device (22) and capture heat energy produced by the at least one electronic data processing device (22) in use;
an energy store (34) configured to store energy; and
a load controller (24) for controlling the at least one electronic data processing device (22), the energy store (34) or the cool matter stream (28a, 28b), the load controller (24) being configured to:
receive an electrical energy regulation parameter enabling a required electrical energy level of the electrical energy generating system to be determined;
receive a heat energy demand parameter enabling a required heat energy demand of the heat energy consuming system to be determined;
generate and send instructions that cause a change in the operation of the at least one data processing device (22), the energy store (34) or the cool matter stream (28a, 28b), wherein the instructions are determined to cause a change in the temperature of the cool matter stream (28a, 28b) to meet the required heat energy demand and/or to cause a change in the electrical energy consumed by or provided to the electrical energy generating system to regulate the electrical energy generating system to meet the required electrical energy level; and
enable output of the cool matter stream (28a, 28b) to the heat energy consuming system to meet at least part of the required heat energy demand and/or electrical energy input from or output to the electrical energy generating system to meet the required electrical energy level.

2. The energy regulator of Claim 1, wherein the energy store (34) comprises an electrical battery and the load controller (24) is configured to provide electrical energy from the battery to the electrical energy generating system to regulate the same.

3. The energy regulator of Claim 2, wherein the load controller (24) is configured to store excess electrical energy received from the electrical energy generating system in the battery.

4. The energy regulator of any of Claims 1 to 3, wherein the energy store (34) comprises an electrical energy generator and the load controller (24) is configured to provide electrical energy from the electrical energy generator to the electrical energy generating system to regulate the same and/or to provide electrical energy to generate heat energy and provide the heat energy to the heat energy consuming system.

5. The energy regulator of any of Claims 1 to 4, wherein the heat energy demand parameter is a required temperature of the cool matter stream (28a, 28b), and the load controller (24) is configured to determine the required heat energy demand using the difference between the required temperature and a current temperature of the cool matter stream (28a, 28b).

6. The energy regulator of any of Claims 1 to 5, wherein the load controller (24) is configured to change the temperature of the cool matter stream (28a, 28b) by increasing or decreasing a clock speed of the at least one data processing device (22).

7. The energy regulator of any of Claims 1 to 6, wherein the load controller (24) is configured to change the temperature of the cool matter stream (28a, 28b) by pausing or restarting operation of the at least one data processing device (22).

8. The energy regulator of any of Claims 1 to 7, further comprising heating circuits (32) thermally coupled, in use, to the cool matter stream (28a, 28b) and configured, under control of the load controller (24) to increase the temperature of the cool matter stream (28a, 28b) independently of the operation of the at least one electronic data processing device (22),
wherein the load controller (24) is configured to change the temperature of the cool matter stream (28a, 28b) by activating or deactivating the heating circuits (32) and controlling the amount of data processing being carried out by the at least one electronic data processing device (22).

9. The energy regulator of any of Claims 1 to 8, further comprising a plurality of modular units, each modular unit comprising an instance of the at least one electronic data processing device (22) and the respective thermally coupled cool matter stream (28a, 28b),
wherein the load controller (24) comprises a plurality of load sub-controllers, each load sub-controller being assigned to one of the plurality of modular units enabling independent operation of each modular unit.

10. The energy regulator of Claim 9, wherein the electrical power consumption of the energy regulator can be varied by activating or deactivating one or more of the plurality of modular units by changing the clock speed of the at least one data processing device (22), or by pausing or restarting operation of the at least one data processing device (22).

11. The energy regulator of any of Claims 1 to 10, wherein the at least one data processing device (22) comprises a crypto-mining server.

12. The energy regulator of any of Claims 1 to 9, wherein the load controller (24) is configured to change the power consumption of the at least one data processing device (22) to meet the required electrical energy level, by changing a rate of operation of the at least one data processing device (22).

13. The energy regulator of any of Claims 1 to 12, wherein the energy regulator is operatively coupled to an external controllable energy consumption resource, and the load controller (24) is configured to change electrical power consumption of the energy regulator by operating the external controllable energy consumption resource.

14. The energy regulator of Claim 13, wherein the external controllable energy consumption resource is a load bank for consuming excess energy, and the load controller (24) is configured to provide electrical energy not required by the electrical energy generating system to the load bank.

15. A method of using an energy regulator to provide electrical energy to or consume electrical energy from an electrical energy generating system and provide heat energy to a heat consuming system, the method comprising:
coupling the energy regulator to the electrical energy generating system and the heat energy consuming system;
processing data using at least one electronic data processing device (22) of the energy regulator;
capturing heat energy produced by the at least one electronic data processing device (22) using a cool matter stream (28a, 28b) thermally coupled to the at least one electronic data processing device;
providing an energy store (34) configured to store energy; and
controlling the at least one electronic data processing device (22), the energy store (34) or the cool matter stream (28a, 28b), the controlling step comprising:
receiving a current electrical energy regulation parameter enabling a required electrical energy level of the electrical energy generating system to be determined;
receiving a current heat energy demand parameter enabling a required heat energy demand of the heat energy consuming system to be determined;
generating and sending instructions that cause a change in the operation of the at least one data processing device (22), the energy store (34) or the cool matter stream (28a, 28b), wherein the instructions are determined to cause a change in the temperature of the cool matter stream (28a, 28b) to meet the required heat energy demand and/or to cause a change in the electrical energy consumed by or provided to the electrical energy generating system to regulate the electrical energy generating system to meet the required electrical energy level; and
enabling output of the cool matter stream (28a, 28b) to the heat energy consuming system to meet at least part of the required heat energy demand; and/or
enabling input or output of electrical energy to or from the electrical energy generating system to meet the required electrical energy level.
